# EUROPEAN PATENT SPECIFICATION

(11) **EP 0 747 930 B1**
(45) Date of publication and mention of the grant of the patent: **27.09.2000**
(21) Application number: 95830214.3
(22) Date of filing: 19.05.1995
(51) Int. Cl.: H01L 21/00, H01L 23/482, H01L 23/528

(54) **Electronic device with multiple bonding wires, method of fabrication and method of testing bonding wire integrity**
Elektronische Schaltung mit mehreren Banddrähten, Herstellungsmethode und Testverfahren des Banddrahtzusammenhangs
Circuit électronique à connexion de fils multiples méthode de fabrication et méthode d'essai de l'intégrité des fils

(43) Date of publication of application: 11.12.1996
(73) Proprietor: STMicroelectronics S.r.l., 20041 Agrate Brianza (Milano) (IT)
(72) Inventor: Chrappan Soldavini, Francesco, I-20091 Bresso (IT); Salina, Alberto, I-20051 Limbiate (IT)
(74) Representative: Cerbaro, Elena, Dr.

(56) References cited:
- US-A- 4 439 841
- US-A- 4 467 345
- US-A- 5 101 154

## Description

The present invention relates to an electronic device with multiple bonding wires, a method of fabricating such a device and a method of testing device bonding wire integrity.

As is known, electronic power devices frequently require the use of two or more bonding wires between the pin of the device package and the die in which the device is formed, when low resistivity is required and/or when the bonding wire is called upon to withstand strong current.

In the case of multiple-wire connections, the problem arises of checking the integrity of all the wires at the final testing stage. To solve this problem, it has been proposed to split the contact pad to which one end of the bonding wires is bonded, as well as the component connected to the pad, and to connect each bonding wire to a respective portion of the split pad to test each wire separately by separately turning on each component connected to it.

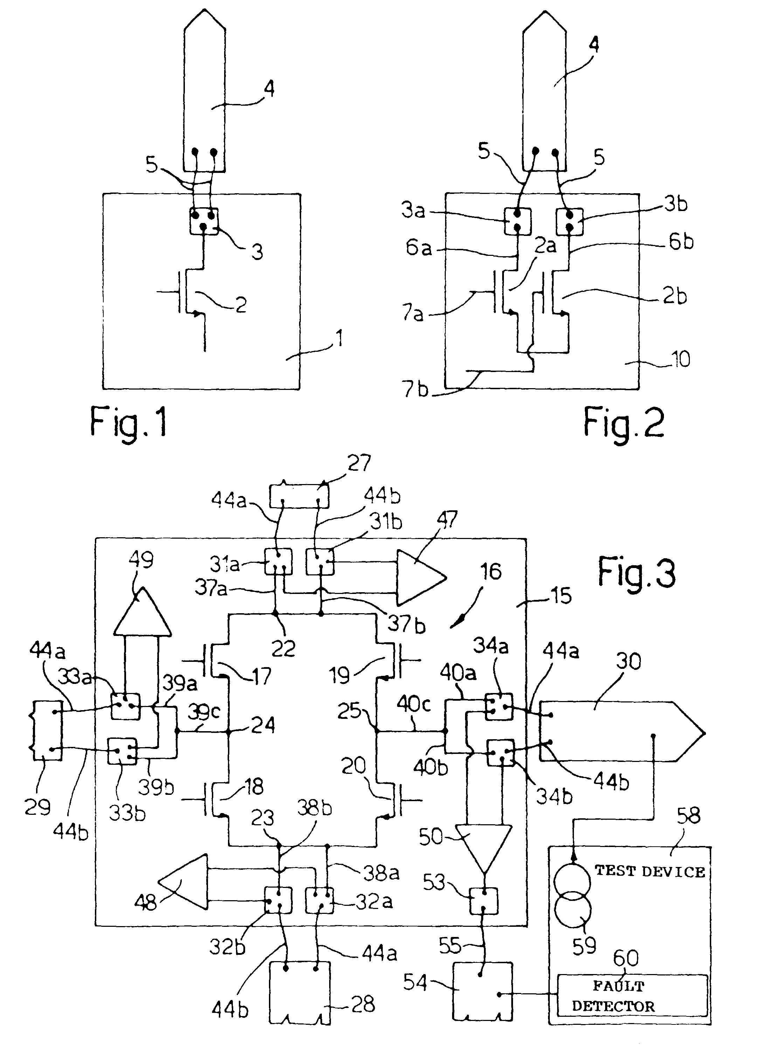

The above solution is shown schematically in Figures 1 and 2. Figure 1 shows, schematically, an electronic device 1 comprising an output stage component (here, a MOS transistor 2), one terminal of which is connected to a contact pad 3 in turn connected to a pin 4 by two wires 5. Figure 2 shows, schematically, the same device - here indicated at 10 - modified according to the above known solution. More specifically, component 2 is split into components 2a, 2b, the output terminals 6a, 6b of which are connected to respective pads 3a, 3b into which pad 3 is split; components 2a, 2b present separate control terminals 7a, 7b for operating them independently; and pin 4 is connected by one wire 5 to pad 3a, and by the other wire 5 to pad 3b.

By turning components 2a, 2b on separately, the above solution therefore provides for determining correct connection of respective wire 5.

Such a solution, however, inevitably complicates the drive stage (not shown) of the device, which must be capable of turning on each component 2a, 2b separately, and requires an additional control for enabling the test function and selecting the output stage to be activated. Moreover, splitting the output components and relative pads, the need for electrically isolating the split components, and the presence of additional components for performing the test functions, considerably increase the area of the electronic device.

This drawback is further compounded when, instead of splitting a single output component, a bridge configuration is involved requiring splitting of all four bridge elements.

US-A-5,101,154 discloses an open bond detector and a method of testing the integrity of the bonding wires of the device according to the preamble of claims 1 and 11. In this document, the detector is arranged between the respective bonding pad and the power supply conductor.

It is an object of the present invention to provide an electronic device, a fabrication method, and a test method designed to overcome the drawbacks typically associated with known solutions, while at the same time ensuring reliable testing of the bonding wire integrity.

According to the present invention, there are provided an electronic device with multiple bonding wires, as claimed in Claim 1; a method of fabricating such a device, as claimed in Claim 6; and a method of testing the integrity of the bonding wires of the device, as claimed in Claim 11.

In practice, the present invention provides for only splitting the contact pads and part of the (metal) line connecting the externally connected terminal of the components to the split pads, so as to achieve a plurality of parallel current paths between the outside terminal of the device and the contact pin. When supplied with current, therefore, the connecting line produces a voltage drop along each of its split portions connected to a sound bonding wire, but not along the split portions connected to broken or nonbonded wires; so that any interruption of one or more of the bonding wires may be detected by measuring any voltage difference between the split pads.

A number of preferred, non-limiting embodiments of the present invention will be described by way of example with reference to the accompanying drawings, in which:
Figure 1 shows a known electronic power device with a multiple bonding wire;
Figure 2 shows a further known power device;
Figure 3 shows a simplified circuit diagram of a device in accordance with the present invention;
Figure 4 shows a detail of part of the layout of the Figure 3 device;
Figure 5 shows a variation of a detail of the Figure 3 device;
Figure 6 shows the electric diagram of the Figure 5 detail.

In the Figure 3 embodiment, the device 15 according to the present invention comprises an output bridge 16, a drive section (not shown), and other electronic components (not shown). In the example shown, the bridge comprises four MOS transistors 17-20 connected to form four nodes 22-25, of which, typically, nodes 22, 23 are connected to the supply and to ground, and nodes 24, 25 form the output of the bridge; nodes 22-25 are all connected outside device 15 by respective pins 27-30; and a two-wire connection is used to ensure low resistivity and a high current carrying capacity, as indicated above.

In the Figure 3 example, the output pads connected to nodes 22-25 are split to form four pairs of output pads 31a,31b, 32a,32b, 33a,33b, 34a,34b connected respectively to nodes 22, 23, 24, 25 by four connecting lines in the form of metal strips. More specifically, the connection between node 22 and output pads 31a, 31b is split and formed of metal line portions 37a, 37b; the connection between node 23 and output pads 32a, 32b is split and formed of metal line portions 38a, 38b; the connection between node 24 and output pads 33a, 33b presents a split metal line portion 39a, 39b (terminating at pads 33a, 33b) and a common metal line portion 39c (extending from node 24); and the connection between node 25 and output pads 34a, 34b presents a split portion 40a, 40b and a common portion 40c. Each pad is connected to the respective pin by a wire 44a, 44b.

Device 15 also comprises four comparators 47-50, one for each pair of pads 31-34, and each presenting two inputs connected to the pads in a respective pair. The outputs of comparators 47-50 are connected externally of device 15 as shown in Figure 3 for comparator 50 only. For this purpose, the device presents a contact pad 53 connected to an own pin 54 by a bonding wire 55.

Figure 3 also shows the connection to a test device 58 comprising a current source 59 connected to pin 30; and a fault detecting and signaling stage 60 connected to pin 54.

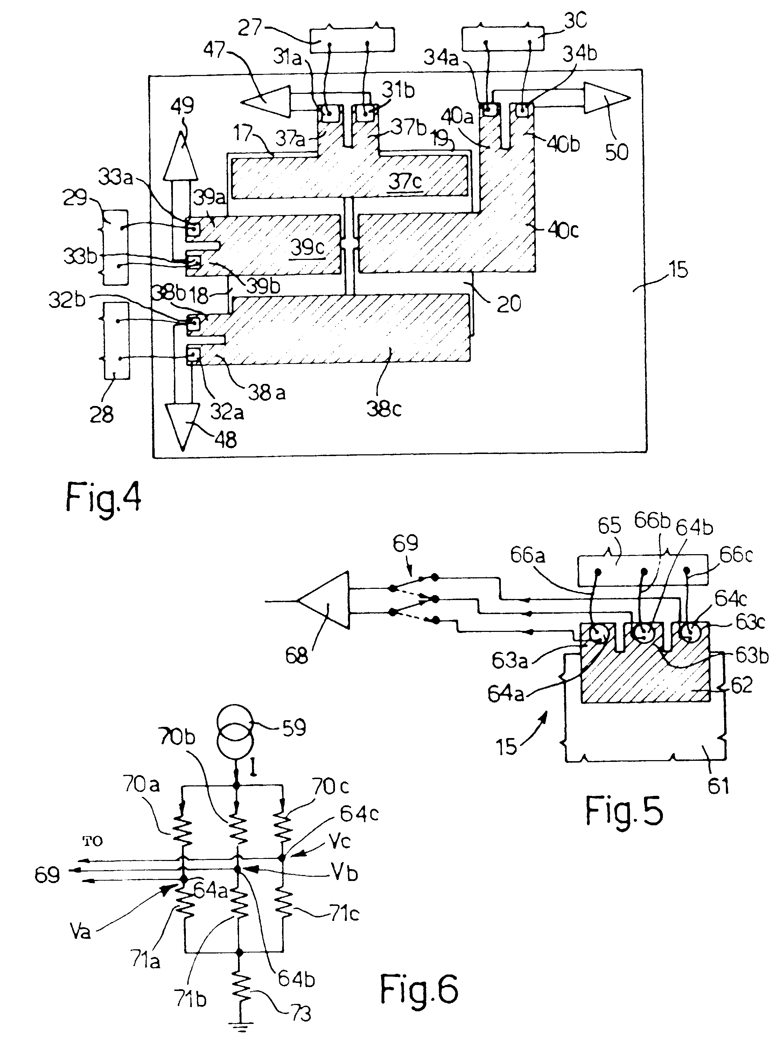

Figure 4 shows a detail of Figure 3 illustrating the actual implementation of connecting lines 37-40 in the form of metal strips indicated using the same numbering system as in Figure 3. In Figure 4, also, transistors 17-20 are shown in the form of rectangles corresponding to the area in which they are integrated; and also shown are the connecting lines between transistors 17-20, formed of portions 38c, 40c for the connections to pads 33, 34, and portions 37c, 39c for the connections to pads 31, 32.

In the Figure 3 and 4 example, the portions of the split metal connecting lines, the relative contact pads, and the respective bonding wires represent pairs of parallel paths. When current is forced along the paths, and if the bonding wires are sound and the paths balanced, the current is divided into half and produces substantially the same small voltage drop along both paths. In actual fact, the difference generally existing in the length of the bonding wires results in a voltage difference at the pads, so that a small difference in potential exists at the inputs of the comparator (50 in Figure 3) connected to the test connection. This difference, however, is generally below the sensitivity of the comparator, or the comparator may be designed with a trigger threshold higher than it, so that its output is zero (logic 0), and a sound connection is indicated by fault detecting and signaling stage 60.

Conversely, if either one of bonding wires 44a, 44b is interrupted (e.g. wire 44a), current only flows, and produces a voltage drop, along one of the parallel paths (path 44b, 34b, 40b). In this case, pad 34b presents a different potential from pad 34a (equal to that at the junction between portions 40a, 40b, 40c); the comparator detects a voltage difference above its trigger threshold, and supplies an output voltage other than zero (logic 1 signal); and the output signal is detected by stage 60 which therefore signals a fault.

The Figure 5 embodiment relates to a three-wire connection. Figure 5 shows only part of device 15, and a component 61 connected externally of device 15 by a metal connecting line 62, the end portion of which is divided into three parts 63a, 63b, 63c; three areas or pads 64a, 64b, 64c connect parts 63 of line 62 to a pin 65 by means of respective bonding wires 66a, 66b, 66c; and areas 64a, 64b, 64c are also connected to the inputs of a comparator 68 via a system of switches 69 (multiplexer) for selectively connecting areas 64a, 64b, 64c to comparator 68 and so permitting the comparator to measure, each time, the potential difference between areas 64a and 64b, areas 64a and 64c, and areas 64b and 64c.

Figure 6 shows an electric diagram of the Figure 5 structure, in which switch system 69 and comparator 68 are not shown; bonding wires 64a, 64b, 64c are represented by resistors 70a, 70b, 70c; parts 63a, 63b, 63c are represented by resistors 71a, 71b, 71c of substantially the same resistance Rₐ, R_{b}, R_{c}; and the common portion of connecting line 62 and the current path through component 61 (and any other components) to ground is represented by resistor 73. Figure 6 also shows the current source 59 for generating current I which is divided into currents Iₐ, I_{b}, I_{c} along the three parallel paths.

If Vₐ, V_{b}, V_{c} are the voltages with respect to ground of areas 64a, 64b, 64c, and if:${\text{ΔV}}_{\text{a,b}} {\text{= V}}_{\text{a}} {\text{-V}}_{\text{b}} {\text{= I}}_{\text{a}} {\text{∗R}}_{\text{a}} {\text{-I}}_{\text{b}} {\text{∗R}}_{\text{b}}$${\text{ΔV}}_{\text{b,c}} {\text{= V}}_{\text{b}} {\text{-V}}_{\text{c}} {\text{= I}}_{\text{b}} {\text{∗R}}_{\text{b}} {\text{-I}}_{\text{c}} {\text{∗R}}_{\text{c}}$${\text{ΔV}}_{\text{a,c}} {\text{= V}}_{\text{a}} {\text{-V}}_{\text{c}} {\text{= I}}_{\text{a}} {\text{∗R}}_{\text{a}} {\text{-I}}_{\text{c}} {\text{∗R}}_{\text{c}}$ and all the connections are sound:${\text{I}}_{\text{a}} {\text{= I}}_{\text{b}} {\text{= I}}_{\text{c}}$ so that:${\text{ΔV}}_{\text{a,b}} {\text{= ΔV}}_{\text{b,c}} {\text{= ΔV}}_{\text{a,c}} \text{= 0.}$

Conversely, if wire 66a is interrupted (broken or improperly bonded), no current flows through resistors 70a, 71a, so that:${\text{ΔV}}_{\text{b,c}} {\text{= 0; ΔV}}_{\text{a,b}} {\text{= ΔV}}_{\text{a,c}} \text{< 0.}$

In the case, for example, of a connecting line with a sheet resistance of R_{□} = 20 mΩ/□ , a length/width L/W ratio of 0.5, and whose terminal portion is divided into parts 63a, 63b, 63c so that they present a L/W ratio of 1.5, this gives Rₐ = R_{b} = R_{c} = R_{□} x L/W = 30 mΩ . If current I equals 1 A, and only wire 66a is broken, Iₐ = 0; and I_{b} = I_{c} = 0.5 A , so that ΔV_{a,b} = ΔV_{a,c} = -15 mV. . If two wires (e.g. 66a, 66b) are broken, Iₐ = I_{b} = 0 ; and I_{C} = 1 A , so that ΔV_{a,c} = ΔV_{b,c} = -30 mV.

On the basis of the voltage difference detected, it is therefore possible to determine if any and how many and which bonding wires are interrupted.

Integrity of the bonding wires is typically checked during final testing of device 15, at the end of fabrication, by connecting device 58 and activating the relative procedure. For externally communicating the outcome of the comparison by the comparator/s, specific pads (and pins) may be provided, as shown in Figure 3, or one or more of the existing pads also used for other functions may be employed. In the latter case, provision must be made for activating the correct function by means of an appropriate input configuration (a special input specifying, instant by instant, the function to be activated) or by programming a device register (an obviously advantageous solution if the device already features memory registers for its functions, in which case, forming a specific register for memorizing and setting the desired function, or adding a dedicated bit in an existing register poses no problem). A command for enabling/disabling the test function may also be provided, as described above, by appropriately programming the inputs and/or by writing a code into one or more registers.

The advantages of the device and test method described are as follows. In particular, they provide for clearly indicating any interruption of the bonding wires with no need for duplicating or multiplying the externally connected components or their control stages. Though the solution described involves an increase in occupied area for forming split or multiplied contact pads and accommodating the comparators, the increase in area due to the comparators may be reduced by providing one comparator, to the inputs of which all the pairs or groups of pads are connected selectively, in which case, however, a switching section is required. Alternatively, the increase in area due to the comparators may be eliminated by locating them outside the device and including them in test device 58. No such increase in area exists in the case of devices already featuring comparators for final testing.

Clearly, changes may be made to the device and test method as described and illustrated herein without, however, departing from the scope of the present invention. In particular, the comparators (in addition to being internal or external) may be formed in any way, bearing in mind that the currents for biasing the input stages may be such as to require turnoff of some or all of the comparators to prevent excessive losses at the contact pads when the power stages (final components) are off. As stated above, provision may be made for one comparator for each pair of pads to be compared, or for a single comparator with a switching section. Moreover, an internal logic circuit may be provided for determining the output of the various comparators, and, in the event any one indicates a fault on any one of the bonding wires, for supplying a fault output signal.

The current source may be external, as shown, or internal, and, for example, supply current through the final components.

## Claims

1. An electronic device (15) including:
- a package having pins (27-30) for connection to the exterior;
- a die (15) having bonding pads (31a, 31b, 32a, 32b, 33a, 33b, 34a, 34b);
- a plurality of bonding wires (44) extending between said bonding pads and said pins;
- a component (17-20) in said die defining a circuit node (22-25) for connecting externally said component;
- an electrically conductive connecting line (37-40) on the die connecting said circuit node (22-25) to said bonding pads; at least a portion of said connecting line comprising a plurality of line portions (37a, 37b, 38a, 38b, 39a, 39b, 40a, 40b) each connecting said circuit node to a respective bonding pad (31-34), said line portions defining, together with said bonding wires (44), parallel current paths between said pins (27-30) and said circuit node (22-25);
- potential difference detecting means (47-50) for detecting interruption of said bonding wires,
characterized in that
said potential difference detecting means (47-50) have inputs connected to pairs of said bonding pads (31a, 31b, 32a, 32b, 33a, 33b, 34a, 34b) so as to determine the potential difference between said pairs of bonding pads and generate a fault output signal in presence of a substantially other than zero value of said potential difference,
and in that it comprises current supply means (59) connected to said pins (27-30) and supplying substantially the same currents along said pairs of parallel current paths.

2. A device as claimed in Claim 1, characterized in that said connecting line (37-40) comprises a metal strip presenting an end portion divided into a plurality of strip portions (37a, 37b, 38a, 38b, 39a, 39b, 40a, 40b) presenting substantially the same resistance.

3. A device as claimed in Claim 2, characterized in that said strip portions (37a, 37b, 38a, 38b, 39a, 39b, 40a, 40b) are identical and extend parallel to one another.

4. A device as claimed in any of Claims 1-3, characterized in that said detecting means comprise a comparator (47-50) having inputs connected to said pairs of bonding pads (31a, 31b, 32a, 32b, 33a, 33b, 34a, 34b).

5. A device as claimed in any of Claims 1-4, characterized in that it comprises switching means (69) for selectively connecting different pairs of bonding pads (31a, 31b, 32a, 32b, 33a, 33b, 34a, 34b) to said potential difference detecting means (47-50).

6. A method of fabricating an electronic device (15) as claimed in any one of the claims 1-5, comprising the steps of:
- forming a die (15) having bonding pads (31a, 31b, 32a, 32b, 33a, 33b, 34a, 34b);
- forming a component (17-20) in said die defining a circuit node (22-25) for connecting externally said component;
- forming a package having pins (27-30) for connection to the exterior;
- forming an electrically conductive connecting line (37-40) on the die connecting said circuit node (22-25) to said bonding pads; at least a portion of said connecting line comprising a plurality of line portions (37a, 37b, 38a, 38b, 39a, 39b, 40a, 40b) each connecting said circuit node to a respective bonding pad (31a, 31b, 32a, 32b, 33a, 33b, 34a, 34b), said line portions defining, together with said bonding wires (44), parallel current paths between said pins and said circuit node;
- bonding a plurality of bonding wires (44) extending between said bonding pads and said pins;
- forming potential difference detecting means (47-50) for detecting interruption of said bonding wires, and
- testing the integrity of said bonding wires (44); characterized in that said step of testing the integrity comprises the steps of:
- supplying equal currents to pairs of said parallel current paths; and
- determining the potential difference between the bonding pads of said pairs of said parallel current paths.

7. A method as claimed in Claim 6, characterized in that said step of forming a plurality of line segments comprises the step of forming a metal strip presenting an end portion divided into a plurality of strip portions presenting a same resistance.

8. A method as claimed in Claim 7, characterized in that said step of forming a metal strip comprises the step of forming identical strip portions extending parallel to each other.

9. A method as claimed in any one of Claims 6-8, characterized in that said step of supplying current comprises the step of supplying current by means of an external current source connected to said external connecting pin.

10. A method as claimed in any one of Claims 6-9, characterized in that said step of determining the potential difference comprises the steps of connecting pairs of said bonding pads to comparing means; determining the potential difference between said pairs of bonding pads; and generating a fault output signal in the presence of a substantially other than zero value of said potential difference.

11. A method of testing the integrity of the bonding wires (44) of an electronic device (15) comprising a package having pins (27-30) for connection to the exterior; a die (15) having bonding pads (31a, 31b, 32a, 32b, 33a, 33b, 34a, 34b); a plurality of bonding wires (44) extending between said bonding pads and said pins; a component (17-20) in said die defining a circuit node (22-25) for connecting externally said component; an electrically conductive connecting line (37-40) on the die connecting said circuit node to said bonding pads; at least a portion of said connecting line comprising a plurality of line portions (37a, 37b, 38a, 38b, 39a, 39b, 40a, 40b) each connecting said circuit node to a respective bonding pad, said line portions defining, together with said bonding wires (44), parallel current paths between said pins (27-30) and said circuit node (22-25); potential difference detecting means (47-50) for detecting interruption of said bonding wires,
characterized by the steps of supplying equal currents to pairs of said parallel current paths; and determining the potential difference between the bonding pads of said pairs of said parallel current paths.

## Patentansprüche

1. Elektronische Vorrichtung (15) mit:
- einer Baugruppe mit Stiften (27 - 30) für die Verbindung nach außen;
- einer Gußplatte (15) mit Anschluß-Kontaktflächen (31a, 31b, 32a, 32b, 33a, 33b, 34a, 34b);
- einer Mehrzahl von Anschlußdrähten (44), die zwischen den Anschluß-Kontaktflächen und den Stiften verlaufen;
- einem Bauelement (17 - 20) auf der Gußplatte, das einen Schaltungsknoten (22 - 25) für seinen externen Anschluß aufweist;
- einer elektrisch leitfähigen Verbindungsleitung (37- 40) auf der Gußplatte, die den Schaltungsknoten (22 - 25) mit den Anschluß-Kontaktflächen verbindet; wobei wenigstens ein Teil der Verbindungsleitung eine Mehrzahl von Leitungsteilen (37a, 37b, 38a, 38b, 39a, 39b, 40a, 40b) umfaßt, von denen jeder den Schaltungsknoten mit einer jeweiligen Anschluß-Kontaktfläche (31 - 34) verbindet und die Leitungsteile zusammen mit den Anschlußdrähten (44) parallele Strompfade zwischen den Stiften (27 - 30) und dem Schaltungsknoten (22 - 25) bilden;
- einer Potentialdifferenz-Detektoreinrichtung (47 - 50) zum Feststellen einer Unterbrechung der Anschlußdrähte,
dadurch gekennzeichnet, daß
die Potentialdifferenz-Detektoreinrichtung (47 - 50) Eingänge hat, die mit Paaren der Anschluß-Kontaktflächen (31a, 31b, 32a, 32b, 33a, 33b, 34a, 34b) verbunden sind, um so die Potentialdifferenz zwischen den beiden Anschluß-Kontaktflächen zu bestimmen und bei Vorhandensein eines Werts, der wesentlich von Null abweicht, dieser Potentialdifferenz ein Fehlerausgangssignal zu erzeugen,
und daß sie eine Stromversorgungseinrichtung (59) umfaßt, die mit den Stiften (27 - 30) verbunden ist und im wesentlichen die gleichen Ströme auf den Paaren der parallelen Strompfade liefert.

2. Vorrichtung nach Anspruch 1, dadurch gekennzeichnet, daß die Verbindungsleitung (37 - 40) einen Metallstreifen umfaßt, der einen in eine Mehrzahl von Streifenteilen (37a, 37b, 38a, 38b, 39a, 39b, 40a, 40b), die im wesentlichen gleichen Widerstand aufweisen, unterteilten Endteil haben.

3. Vorrichtung nach Anspruch 2, dadurch gekennzeichnet, daß die Streifenteile (37a, 37b, 38a, 38b, 39a, 39b, 40a, 40b) identisch sind und parallel zueinander verlaufen.

4. Vorrichtung nach einem der Ansprüche 1 bis 3, dadurch gekennzeichnet, daß die Detektoreinrichtung einen Komparator (47 - 50) mit Eingängen, die mit den Paaren der Anschluß-Kontaktflächen (31a, 31b, 32a, 32b, 33a, 33b, 34a, 34b) verbunden sind, umfaßt.

5. Vorrichtung nach einem der Ansprüche 1 bis 4, dadurch gekennzeichnet, daß sie eine Schalteinrichtung (69) zum selektiven Verbinden unterschiedlicher Paare von Anschluß-Kontaktflächen (31a, 31b, 32a, 32b, 33a, 33b, 34a, 34b) mit der Potentialdifferenz-Detektoreinrichtung (47 - 50) umfaßt.

6. Verfahren zum Herstellen einer elektronischen Vorrichtung (15) nach einem der Ansprüche 1 bis 5, mit den folgenden Verfahrensschritten:
- Bilden einer Gußplatte (15) mit Anschluß-Kontaktflächen (31a, 31b, 32a, 32b, 33a, 33b, 34a, 34b);
- Bilden eines Bauelements (17 - 20) auf dieser Gußplatte, das einen Schaltungsknoten (22 - 25) zum externen Anschluß des Bauelements bestimmt;
- Bilden einer Baugruppe mit Stiften (27 - 30) zur Verbindung nach außen;
- Bilden einer elektrisch leitfähigen Verbindungsleitung (37 - 40) auf der Gußplatte, die den Schaltungsknoten (22 - 25) mit den Anschluß-Kontaktflächen verbindet; wobei wenigstens ein Teil der Verbindungsleitung eine Mehrzahl von Leitungsteilen (37a, 37b, 38a, 38b, 39a, 39b, 40a, 40b) umfaßt, von denen jeder den Schaltungsknoten mit einer jeweiligen Anschluß-Kontaktfläche (31a, 31b, 32a, 32b, 33a, 33b, 34a, 34b) verbindet und die Leitungsteile zusammen mit den Anschlußdrähten (44) parallele Strompfade zwischen den Stiften und dem Schaltungsknoten bilden;
- Anschließen einer Mehrzahl von Anschlußdrähten (44), die zwischen den Anschluß-Kontaktflächen und den Stiften verlaufen;
- Bilden einer Potentialdifferenz-Detektoreinrichtung (47 - 50) zum Feststellen einer Unterbrechung der Anschlußdrähte; und
- Prüfen der Integrität der Anschlußdrähte (44);
dadurch gekennzeichnet, daß der Schritt des Prüfens der Integrität die folgenden Schritte umfaßt:
- Liefern gleicher Ströme an die paarweisen parallelen Strompfade; und
- Bestimmen der Potentialdifferenz zwischen den Anschluß-Kontaktflächen der paarweisen parallelen Strompfade.

7. Verfahren nach Anspruch 6, dadurch gekennzeichnet, daß der Schritt der Bildung einer Mehrzahl von Leitungsabschnitten den Schritt umfaßt, einen Metallstreifen zu bilden, der einen in eine Mehrzahl von Streifenteilen, die gleichen Widerstand aufweisen, unterteilten Endteil hat.

8. Verfahren nach Anspruch 7, dadurch gekennzeichnet, daß der Schritt der Bildung eines Metallstreifens den Schritt umfaßt, identische Streifenteile zu bilden, die parallel zueinander verlaufen.

9. Verfahren nach einem der Ansprüche 6 bis 8, dadurch gekennzeichnet, daß der Schritt des Lieferns von Strom den Schritt umfaßt, Strom mit Hilfe einer externen Stromquelle, die mit dem externen Verbindungsstift verbunden ist, zu liefern.

10. Verfahren nach einem der Ansprüche 6 bis 9, dadurch gekennzeichnet, daß der Schritt der Bestimmung der Potentialdifferenz die folgenden Schritte umfaßt: Verbinden der Paare der Anschluß-Kontaktflächen mit Vergleichseinrichtungen; Bestimmen der Potentialdifferenz zwischen den paarweisen Anschluß-Kontaktflächen; und Erzeugen eines Fehlerausgangssignals bei Vorhandensein eines von Null wesentlich abweichenden Werts der Potentialdifferenz.

11. Verfahren zum Prüfen der Integrität der Anschlußdrähte (44) einer elektronischen Vorrichtung (15), die umfaßt: eine Baugruppe mit Stiften (27 - 30) für die Verbindung nach außen; eine Gußplatte (15) mit Anschluß-Kontaktflächen (31a, 31b, 32a, 32b, 33a, 33b, 34a, 34b); eine Mehrzahl von Anschlußdrähten (44), die zwischen den Anschluß-Kontaktflächen und den Stiften verlaufen; ein Bauelement (17 - 20) auf der Gußplatte, das einen Schaltungsknoten (22 - 25) zum externen Anschließen des Bauelements bildet; eine elektrisch leitfähige Verbindungsleitung (37 - 40) auf der Gußplatte, die den Schaltungsknoten mit den Anschluß-Kontaktflächen verbindet, wobei wenigstens ein Teil der Verbindungsleitung eine Mehrzahl von Leitungsteilen (37a, 37b, 38a, 38b, 39a, 39b, 40a, 40b) umfaßt, von denen jeder den Schaltungsknoten mit einer jeweiligen Anschluß-Kontaktfläche verbindet, und wobei die Leitungsteile zusammen mit den Anschlußdrähten (44) parallele Strompfade zwischen den Stiften (27 - 30) und dem Schaltungsknoten (22 - 25) bilden; und Potentialdifferenzdetektoreinrichtungen (47 - 50) zum Feststellen einer Unterbrechung der Anschlußdrähte, gekennzeichnet durch die Schritte, daß man gleiche Ströme an Paare der parallelen Strompfade liefert und die Potentialdifferenz zwischen den Anschluß-Kontaktflächen der Paare der parallelen Strompfade bestimmt.

## Revendications

1. Dispositif électronique (15) comprenant :
- un boîtier comprenant des broches (27-30) pour permettre une connexion avec l'extérieur ;
- une puce (15) comportant des plages de connexion (31a, 31b, 32a, 32b, 33a, 33b, 34a, 34b) ;
- une pluralité de fils de liaison (44) s'étendant entre lesdites plages de connexion et lesdites broches ;
- un composant (17-20) situé dans ladite puce et définissant un noeud de circuit (22-25) pour la connexion externe dudit composant ;
- une ligne de connexion électriquement conductrice (37-40) située sur la puce reliant ledit noeud de circuit (22-25) auxdites plages de connexion; au moins une partie de ladite ligne de connexion comprenant une pluralité de parties de ligne (37a, 37b, 38a, 38b, 39a, 39b, 40a, 40b) connectant chacune ledit noeud de circuit à une plage de connexion respective (31-34), lesdites parties de ligne définissant, conjointement avec lesdits fils de liaison (44), des trajets de courant parallèles entre lesdites broches (27-30) et ledit noeud de circuit (22-25);
- des moyens (47-50) de détection de différence de potentiel pour détecter une interruption desdits fils de liaison,
caractérisé en ce que
lesdits moyens (47-50) de détection de la différence de potentiel possèdent des entrées raccordées à des paires desdites plages de connexion (31a, 31b, 32a, 32b, 33a, 33b, 34a, 34b) de manière à déterminer la différence de potentiel entre lesdites paires de plages de connexion et produire un signal de sortie de défaut en présence d'une valeur de ladite différence de potentiel nettement différente de zéro, et
en ce qu'il comporte des moyens d'alimentation en courant (59) connectés auxdites broches (27-30) et délivrant essentiellement les mêmes courants le long desdites paires de trajets de courant parallèles.

2. Dispositif selon la revendication 1, caractérisé en ce que ladite ligne de connexion (37-40) comprend une bande métallique possédant une partie d'extrémité divisée en une pluralité de portions de bande (37a, 37b, 38a, 38b, 39a, 39b, 40a, 40b) possédant essentiellement la même valeur résistive.

3. Dispositif selon la revendication 2, caractérisé en ce que lesdites portions de bande (37a, 37b, 38a, 38b, 39a, 39b, 40a, 40b) sont identiques et s'étendent parallèlement les unes aux autres.

4. Dispositif selon l'une quelconque des revendications 1 à 3, caractérisé en ce que lesdits moyens de détection comprennent un comparateur (47-50) comportant des entrées connectées auxdites paires de plages de connexion (31a, 31b, 32a, 32b, 33a, 33b, 34a, 34b).

5. Dispositif selon l'une quelconque des revendications 1 à 4, caractérisé en ce qu'il comprend des moyens de commutation (69) servant à connecter sélectivement différentes paires de plages de connexion (31a, 31b, 32a, 32b, 33a, 33b, 34a, 34b) auxdits moyens (47-50) de détection d'une différence de potentiel.

6. Procédé pour fabriquer un dispositif électronique (15) selon l'une quelconque des revendications 1 à 5, comprenant les étapes consistant à :
- former une puce (15) comportant des plages de connexion (31a, 31b, 32a, 32b, 33a, 33b, 34a, 34b) ;
- former un composant (17-20) dans ladite puce définissant un noeud de circuit (22-25) pour la connexion externe dudit composant ;
- former un boîtier possédant des broches (27-30) pour permettre une connexion avec l'extérieur ;
- former une ligne de connexion électriquement conductrice (37-40) sur la matrice reliant ledit noeud de circuit (22-25) auxdites plages de connexion ; au moins une partie de ladite ligne de connexion comprenant une pluralité de portions de ligne (37a, 37b, 38a, 38b, 39a, 39b, 40a, 40b) connectant chacune ledit noeud de circuit à une plage de connexion respective (31a, 31b, 32a, 32b, 33a, 33b, 34a, 34b), lesdites portions de ligne définissant, conjointement avec lesdits fils de liaison (44), des trajets de courant parallèles entre lesdites broches et ledit noeud de circuit ;
- relier une pluralité de fils de liaison (44) s'étendant entre lesdites plages de connexion et lesdites broches ;
- former des moyens (47-50) de détection d'une différence de potentiel pour détecter une interruption desdits fils de liaison ; et
- tester l'intégrité desdits fils de liaison (44) ;
caractérisé en ce que ladite étape de test d'intégrité comprend les étapes consistant à :
- appliquer des courants égaux à des paires desdits trajets de courant parallèles ; et
- déterminer la différence de potentiel entre les plages de connexion desdites paires desdits trajets de courant parallèles.

7. Procédé selon la revendication 6, caractérisé en ce que ladite étape de formation d'une pluralité de segments de ligne comprend l'étape consistant à former une bande métallique possédant une partie d'extrémité divisée en une pluralité de portions de bande présentant une valeur résistive identique.

8. Procédé selon la revendication 7, caractérisé en ce que ladite étape de formation d'une bande métallique comprend l'étape de formation de portions identiques de bande s'étendant parallèlement les unes aux autres.

9. Procédé selon l'une quelconque des revendications 6 à 8, caractérisé en ce que ladite étape d'alimentation en courant comprend l'étape consistant à envoyer un courant au moyen d'une source de courant externe raccordée à ladite broche de connexion externe.

10. Procédé selon l'une quelconque des revendications 6 à 9, caractérisé en ce que ladite étape de détermination de la différence de potentiel comprend les étapes consistant à connecter des paires desdites plages de connexion à des moyens de comparaison ; déterminer la différence de potentiel entre lesdites paires de plages de connexion ; et produire un signal de sortie de défaut en présence d'une valeur de ladite différence de potentiel nettement différente de zéro.

11. Procédé pour tester l'intégrité des fils de liaison (44) d'un dispositif électronique (15) comprenant un boîtier comprenant des broches (27-30) pour permettre une connexion avec l'extérieur; une puce (15) comportant des plages de connexion (31a, 31b, 32a, 32b, 33a, 33b, 34a, 34b) ; une pluralité de fils de liaison (44) s'étendant entre lesdites plages de connexion et lesdites broches ; un composant (17-20) situé dans ladite puce définissant un noeud de circuit (22-25) pour la connexion externe dudit composant; une ligne de connexion électriquement conductrice (37-40) située sur la puce reliant ledit noeud de circuit auxdites plages de connexion ; au moins une partie de ladite ligne de connexion comprenant une pluralité de parties de ligne (37a, 37b, 38a, 38b, 39a, 39b, 40a, 40b) raccordant chacune ledit noeud de circuit à une plage de connexion respective, lesdites portions de ligne définissant, conjointement avec lesdits fils de liaison (44), des trajets de courant parallèles entre lesdites broches (27-30) et ledit noeud de circuit (22-25) ; des moyens (47-50) de détection d'une différence de potentiel pour détecter une interruption desdits fils de liaison,
caractérisé par les étapes consistant à envoyer des courants identiques à des paires desdits trajets de courant parallèles ; et déterminer la différence de potentiel entre les plages de connexion desdites paires desdits trajets de courant parallèles.
